# FASCICULE DE BREVET EUROPEEN

(11) **EP 4 004 987 B1**
(45) Date de publication et mention de la délivrance du brevet: **16.08.2023**
(21) Numéro de dépôt: 20757633.1
(22) Date de dépôt: 22.07.2020
(51) Int. Cl.: H01L 31/118, H01L 27/146, H01L 27/144

(54) **DISPOSITIF MONOBLOC DE DÉTECTION DE PARTICULES À MATÉRIAU SEMI-CONDUCTEUR**
EINTEILIGE VORRICHTUNG ZUM NACHWEIS VON PARTIKELN MIT HALBLEITERMATERIAL
ONE-PIECE DEVICE FOR DETECTING PARTICLES WITH SEMICONDUCTOR MATERIAL

(30) Priorité: 26.07.2019 FR 1908506
(43) Date de publication de la demande: 01.06.2022
(73) Titulaire: Université d'Aix Marseille, 13284 Marseille Cedex 07 (FR); Centre National de la Recherche Scientifique, 75794 Paris Cedex 16 (FR)
(72) Inventeur: VERVISCH, Wilfried, 13680 Lançon-Provence (FR)
(74) Mandataire: Bonnet, Michel
(86) Numéro de dépôt international: PCT/FR2020/051335
(87) Numéro de publication internationale: WO 2021/019155

(56) Documents cités:
- FR-A1- 3 051 557
- US-A- 5 336 890
- US-A1- 2008 099 871
- US-B1- 6 465 857

## Description

La présente invention concerne un dispositif monobloc de détection de particules à matériau semi-conducteur.

La notion de « particules » doit ici être prise au sens large et inclut des particules élémentaires ou composites de la matière telles que les hadrons (neutrons, protons, ...) ou leptons, ainsi que des particules électromagnétiques (conformément au principe de dualité onde-corpuscule) i.e. les photons tels que les rayons ultraviolets, infrarouges, X, gamma ou autres. Il s'agit d'une façon générale de tout type de particule susceptible de produire des porteurs de charges dans une zone de charge d'espace électronique formée dans un matériau semi-conducteur, ces porteurs de charges étant alors récupérés par des collecteurs d'un détecteur. Ces collecteurs sont en pratique des électrodes situées de part et d'autre du semi-conducteur.

Ce type de détecteur est essentiellement employé pour la détection et la mesure de particules émanant d'un faisceau de particules énergétiques, notamment des particules à hautes énergies, issu d'une source et visant une cible, le dispositif de détection étant alors placé entre les deux pour être traversé par le faisceau incident selon un axe principal. Les applications industrielles sont multiples non seulement dans le domaine médical, par exemple en radiothérapie, protonthérapie ou imagerie médicale, mais également dans les domaines nucléaire, militaire, en surveillance/sécurité ou autre.

Un tel dispositif de détection permet en général de lire, de surveiller, de contrôler, même d'asservir la source du faisceau afin de maîtriser précisément la dose émise et de vérifier l'énergie des particules. Possédant avantageusement des propriétés de transparence aux particules pour minimiser toute influence de la mesure sur le faisceau incident, c'est-à-dire présentant un coefficient de transmission élevé du faisceau qui le traverse, il permet la lecture de ce faisceau, et, via un calculateur, la mesure des flux de rayonnement ionisant émis par la source afin de réajuster la dose et/ou l'énergie délivrée et de vérifier l'homogénéité du faisceau. En radiothérapie par exemple, cela permet de réduire significativement les risques de surdosage. En imagerie médicale, cela permet également d'obtenir une lecture des pixels sensiblement plus stable conduisant à une amélioration de la qualité des images lors de leur traitement.

La transparence est une propriété très importante parce qu'il est essentiel de ne pas altérer le faisceau pour des raisons de conservation d'énergie et de coûts, la consommation énergétique des irradiations pouvant atteindre plusieurs kWh voire MWh en radiothérapie, mais également pour des raisons de robustesse du composant qui effectue la lecture du faisceau traversant, des dépôts d'énergie parfois conséquents pouvant l'altérer pendant la traversée du faisceau et réduire sa durée de vie. Elle est également importante pour des questions de limitation de quantité de chaleur produite et pour ne pas avoir besoin de s'encombrer d'un système de refroidissement.

C'est la raison pour laquelle l'invention s'applique plus particulièrement à un dispositif monobloc de détection de particules à matériau semi-conducteur comportant :
- une couche de substrat,
- au moins une couche supplémentaire du matériau semi-conducteur et/ou d'au moins un matériau conducteur disposée sur une première face de la couche de substrat de manière à former un premier détecteur comprenant :
   - une première zone de charge d'espace électronique traversée par un premier axe principal du dispositif de détection destiné à être suivi par un faisceau de particules, et
   - des premiers moyens collecteurs de porteurs de charges produits par une traversée du faisceau de particules dans la première zone de charge d'espace.

Un tel dispositif est par exemple divulgué dans le document de brevet DE 42 07 431 A1.

US6465857 décrit également un dispositif monobloc de détection de particules,

Outre les avantages thermodynamiques et même mécaniques que présentent certains matériaux semi-conducteurs, ce sont essentiellement les paramètres de fonctionnement électronique qui ont montré le véritable intérêt de ce type de dispositif de détection par rapport aux technologies conventionnelles de chambres d'ionisation ou de scintillateurs. La détection est plus rapide et plus transparente. On obtient par exemple des temps de réponse de l'ordre de la nanoseconde contre la microseconde pour les détecteurs à chambres d'ionisation. Une transparence absolue, définie comme étant le rapport entre l'intégrale de l'énergie de chaque particule recueillie après avoir traversé le détecteur et l'énergie totale du faisceau incident, supérieure à 98 % peut en outre être atteinte pour un dispositif de détection à matériau semi-conducteur SiC de 300 µm et pour un faisceau de particules à 6 MeV.

Pour améliorer la transparence du dispositif de détection, il est possible de jouer sur l'épaisseur du matériau semi-conducteur jusqu'à un certain point. Il est même proposé une astuce dans le document de brevet WO 2017/198630 A1, consistant à prévoir un orifice dans le matériau semi-conducteur en regard de la zone de charge d'espace limitant ainsi l'épaisseur traversée par le faisceau incident.

Mais une tendance consistant à renforcer la sécurité des appareils émetteurs de particules impose de plus en plus une redondance dans les analyses de faisceaux par double détection simultanée à l'aide de deux détecteurs indépendants. Cette tendance s'explique notamment par les applications médicales dans lesquelles un surdosage peut être dangereux. C'est d'autant plus sensible que certaines avancées thérapeutiques, notamment en oncologie, montrent tout l'intérêt de traiter vite et fort, c'est-à-dire d'émettre des faisceaux impulsionnels brefs mais de forte énergie et de grande précision. C'est également valable dans d'autres domaines que l'oncologie et plus généralement que le médical. Dans ce cas, il est important de maîtriser parfaitement le dosage en émission, car tout mauvais dosage peut être lourd de conséquences, de sorte que la double détection s'impose de plus en plus en tant qu'exigence définie par les nouvelles normes ou certifications.

La solution qui s'impose naturellement face à cette nouvelle exigence est de placer deux dispositifs de détection indépendants sur deux capteurs différents dans le trajet du faisceau incident. Mais cette solution nuit à l'encombrement, au coût et surtout à la transparence de l'ensemble.

On connaît du document de brevet US 2008/0099871 A1 un dispositif monobloc de détection de particules à matériau semi-conducteur pouvant comporter un réseau de détecteurs, mais ces derniers ne sont pas indépendants. En effet, ce qui est par exemple décrit aux paragraphes [0038]-[0044] de ce document US 2008/0099871 A1 c'est un unique détecteur à deux jonctions PN, localisées en faces avant et arrière d'un matériau semi-conducteur mais raccordées électriquement entre elles ([0044]). De façon similaire, le document de brevet US 5,336,890 porte sur un dispositif monobloc de détection de particules à matériau semi-conducteur comprenant deux jonctions avec des régions de charge d'espace associées, mais les moyens collecteurs respectifs ne sont pas électriquement isolés pour assurer l'indépendance de deux détecteurs. La figure 1 de ce document US 5,336,890 n'illustre qu'un seul détecteur.

Il peut ainsi être souhaité de prévoir un dispositif de détection de particules à matériau semi-conducteur qui permette de s'affranchir d'au moins une partie des problèmes et contraintes précités.

Il est donc proposé un dispositif monobloc de détection de particules à matériau semi-conducteur comportant :
- une couche de substrat,
- au moins une couche supplémentaire du matériau semi-conducteur et/ou d'au moins un matériau conducteur disposée sur une première face de la couche de substrat de manière à former un premier détecteur comprenant :
   - une première zone de charge d'espace électronique traversée par un premier axe principal du dispositif de détection destiné à être suivi par un faisceau de particules, et
   - des premiers moyens collecteurs de porteurs de charges produits par une traversée du faisceau de particules dans la première zone de charge d'espace,
comportant en outre au moins une autre couche supplémentaire du matériau semi-conducteur et/ou dudit au moins un matériau conducteur disposée sur une deuxième face de la même couche de substrat, opposée à la première face, de manière à former un deuxième détecteur comprenant :
- une deuxième zone de charge d'espace électronique, traversée par un deuxième axe principal du dispositif de détection destiné à être également suivi par le faisceau de particules, et
- des deuxièmes moyens collecteurs de porteurs de charges produits par une traversée du faisceau de particules dans la deuxième zone de charge d'espace.

Il convient de préciser que la couche de substrat est formée dans le matériau semi-conducteur. Ladite au moins une couche supplémentaire est formée dans le matériau semi-conducteur et/ou dans ledit au moins un matériau conducteur disposée sur une première face de la couche de substrat. Enfin, lesdits premier et deuxième axes, pouvant être qualifiés de principaux ou pas, sont nécessairement parallèles pour pouvoir être suivis par le même faisceau de particules.

Il convient également de noter que toute « couche supplémentaire » ou « autre couche supplémentaire » définie comme formée dans le même matériau semi-conducteur que la couche de substrat s'en distingue par un dopage différent et est présentée comme telle par convention dans la présente demande de brevet. Ainsi, la couche de substrat au sens de la présente invention ne s'étend pas nécessairement dans tout le matériau semi-conducteur et toute « couche supplémentaire » ou « autre couche supplémentaire » n'en constitue pas une région, même si elle est définie comme formée dans ce même matériau semi-conducteur. Cette convention se distingue de celle choisie dans le document précité US 2008/0099871 A1 et ne nuit pas pour autant à la cohérence de la présente demande de brevet.

Avantageusement, ladite au moins une autre couche supplémentaire est formée dans le matériau semi-conducteur et/ou dans ledit au moins un matériau conducteur de sorte que ledit au moins un deuxième détecteur soit indépendant du premier tout en étant formé à partir de cette même couche de substrat.

Avantageusement également, les deuxièmes moyens collecteurs sont électriquement isolés des premiers moyens collecteurs pour assurer l'indépendance des premier et deuxième détecteurs.

Ainsi, deux détecteurs indépendants sont formés dans un même dispositif monobloc à partir d'un même substrat commun, de part et d'autre de ce dernier, pour permettre la double détection redondante de plus en plus exigée. On améliore alors l'encombrement, le coût et la transparence de la double détection en faisant l'économie d'une épaisseur de substrat par rapport à la solution précitée. Ce faisant, on s'affranchit en outre du risque de réduction de durée de vie que les capteurs conventionnels subissent actuellement.

De façon optionnelle, un dispositif monobloc de détection de particules selon l'invention peut comporter :
- une première couche supplémentaire dudit au moins un matériau conducteur, disposée directement sur la première face de la couche de substrat ou indirectement via une couche supplémentaire du matériau semi-conducteur formée par épitaxie à partir de la couche de substrat, de manière à former une anode et une cathode d'une première diode Schottky, et
- une deuxième couche supplémentaire dudit au moins un matériau conducteur, disposée directement sur la deuxième face de la couche de substrat ou indirectement via une couche supplémentaire du matériau semi-conducteur formée par épitaxie à partir de la couche de substrat, de manière à former une anode et une cathode d'une deuxième diode Schottky.

En d'autres termes équivalents :
- ladite au moins une couche supplémentaire comporte :
   - une première couche supplémentaire formée dans ledit au moins un matériau conducteur, disposée directement sur la première face de la couche de substrat, ou
   - une première couche supplémentaire formée dans le matériau semi-conducteur par épitaxie à partir de la couche de substrat et la première couche supplémentaire formée dans ledit au moins un matériau conducteur disposée indirectement sur la première face de la couche de substrat via cette première couche supplémentaire formée dans le matériau semi-conducteur,
   de manière à former une anode et une cathode d'une première diode Schottky, et
- ladite au moins une autre couche supplémentaire comporte :
   - une deuxième couche supplémentaire formée dans ledit au moins un matériau conducteur, disposée directement sur la deuxième face de la couche de substrat, ou
   - une deuxième couche supplémentaire formée dans le matériau semi-conducteur par épitaxie à partir de la couche de substrat et la deuxième couche supplémentaire formée dans ledit au moins un matériau conducteur disposée indirectement sur la deuxième face de la couche de substrat via cette deuxième couche supplémentaire formée dans le matériau semi-conducteur,
   de manière à former une anode et une cathode d'une deuxième diode Schottky.

De façon optionnelle également, un dispositif monobloc de détection de particules selon l'invention peut comporter :
- une première couche supplémentaire dudit au moins un matériau conducteur dont au moins un conducteur est au contact d'au moins une portion de couche supplémentaire dudit au moins un matériau semi-conducteur formée avec un dopage inverse de celui de la couche de substrat de manière à former une première diode PIN, et
- une deuxième couche supplémentaire dudit au moins un matériau conducteur dont au moins un conducteur est au contact d'au moins une portion de couche supplémentaire dudit au moins un matériau semi-conducteur formée avec un dopage inverse de celui de la couche de substrat de manière à former une deuxième diode PIN.

En d'autres termes équivalents :
- ladite au moins une couche supplémentaire comporte au moins une première portion de couche supplémentaire formée dans le matériau semi-conducteur avec un dopage inverse de celui de la couche de substrat et une première couche supplémentaire formée dans ledit au moins un matériau conducteur dont au moins un conducteur est au contact de ladite au moins une première portion de couche supplémentaire formée dans le matériau semi-conducteur, de manière à former une première diode PIN, et
- ladite au moins une autre couche supplémentaire comporte au moins une deuxième portion de couche supplémentaire formée dans le matériau semi-conducteur avec un dopage inverse de celui de la couche de substrat et une deuxième couche supplémentaire formée dans ledit au moins un matériau conducteur dont au moins un conducteur est au contact de ladite au moins une deuxième portion de couche supplémentaire formée dans le matériau semi-conducteur, de manière à former une deuxième diode PIN.

De façon optionnelle également, un dispositif monobloc de détection de particules selon l'invention peut comporter deux couches tampon respectivement formées par épitaxie à partir des première et deuxième faces de la couche de substrat.

De façon optionnelle également, un dispositif monobloc de détection de particules selon l'invention peut comporter deux orifices creusés dans le matériau semi-conducteur de part et d'autre de la couche de substrat autour respectivement des premier et deuxième axes principaux destinés à être suivis par le faisceau de particules.

De façon optionnelle également, la couche de substrat est dopée n++.

De façon optionnelle également, plusieurs premiers détecteurs et plusieurs deuxièmes détecteurs sont formés dans le dispositif monobloc.

De façon optionnelle également, ledit au moins un deuxième détecteur est formé de manière à présenter un décalage angulaire à angle droit par rapport audit au moins un premier détecteur selon les premier et deuxième axes principaux destinés à être suivis par le faisceau de particules.

En d'autres termes équivalents, lequel ledit au moins un deuxième détecteur est formé de manière à présenter des diodes en décalage angulaire à angle droit par rapport à des diodes correspondantes dudit au moins un premier détecteur autour de la direction commune des premier et deuxième axes parallèles destinés à être suivis par le faisceau de particules.

De façon optionnelle également, la couche de substrat commune aux détecteurs est formée dans le matériau semi-conducteur.

De façon optionnelle également, le premier axe principal et le deuxième axe principal sont confondus.

L'invention sera mieux comprise à l'aide de la description qui va suivre, donnée uniquement à titre d'exemple et faite en se référant aux dessins annexés dans lesquels :
[Fig.1] la figure 1 représente schématiquement en coupe la structure générale d'un dispositif monobloc de détection de particules, selon un premier mode de réalisation de l'invention,
[Fig.2] la figure 2 représente schématiquement en coupe la structure générale d'un dispositif monobloc de détection de particules, selon un deuxième mode de réalisation de l'invention,
[Fig.3] la figure 3 représente schématiquement en coupe la structure générale d'un dispositif monobloc de détection de particules, selon un troisième mode de réalisation de l'invention,
[Fig.4] la figure 4 représente schématiquement en coupe la structure générale d'un dispositif monobloc de détection de particules, selon un quatrième mode de réalisation de l'invention,
[Fig.5] la figure 5 représente schématiquement en coupe la structure générale d'un dispositif monobloc de détection de particules, selon un cinquième mode de réalisation de l'invention,
[Fig.6] la figure 6 représente schématiquement en coupe la structure générale d'un dispositif monobloc de détection de particules, selon un sixième mode de réalisation de l'invention,
[Fig.7] la figure 7 représente schématiquement en coupe la structure générale d'un dispositif monobloc de détection de particules, selon un septième mode de réalisation de l'invention, et
[Fig.8] la figure 8 représente plus précisément en coupe la structure d'un dispositif monobloc de détection de particules, selon un huitième mode de réalisation de l'invention.

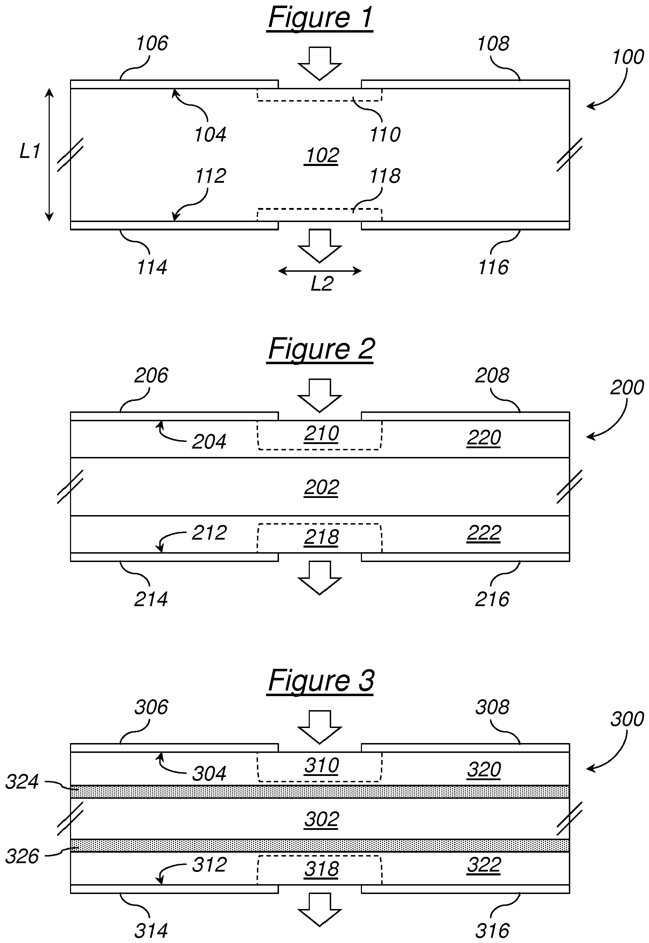

Le dispositif monobloc 100 de détection de particules représenté schématiquement en coupe sur la figure 1 comporte une couche de substrat 102 d'épaisseur L1, par exemple 300 µm. Elle est avantageusement constituée d'un matériau semi-conducteur, de préférence un semi-conducteur à grande largeur de bande d'énergie interdite tel que le carbure de silicium SiC, le diamant ou le nitrure de gallium GaN. Elle est par exemple dopée n++, mais pourrait en variante être dopée p++.

Le dispositif 100 comporte en outre une couche supplémentaire supérieure de matériau conducteur métallique disposée directement sur une première face supérieure 104 de la couche de substrat 102. Cette couche supplémentaire supérieure est constituée de deux conducteurs métalliques disjoints 106 et 108, c'est-à-dire isolés électriquement l'un de l'autre, dont l'un, par exemple celui portant la référence 106, remplit une fonction d'anode et l'autre, par exemple celui portant la référence 108, remplit une fonction de cathode.

Une première diode Schottky formant un premier détecteur est ainsi constituée par formation d'une première zone de charge d'espace 110 dans le substrat 102 sous sa première face supérieure 104 entre les deux conducteurs 106 et 108. Cette première zone de charge d'espace 110 est traversée par un axe principal du dispositif de détection 100 destiné à être suivi par un faisceau de particules, comme illustré sur la figure 1 par les deux flèches descendantes. L'anode 106 et la cathode 108, formant ainsi respectivement un contact Schottky et un contact ohmique de la première diode Schottky, constituent des premiers moyens collecteurs de porteurs de charges produits par une traversée du faisceau de particules dans la première zone de charge d'espace 110.

Le dispositif 100 comporte en outre une autre couche supplémentaire inférieure de matériau conducteur métallique disposée directement sur une deuxième face inférieure 112 de la couche de substrat 102. Cette autre couche supplémentaire inférieure est constituée de deux conducteurs métalliques disjoints 114 et 116 dont l'un, par exemple celui portant la référence 114, remplit une fonction d'anode et l'autre, par exemple celui portant la référence 116, remplit une fonction de cathode.

Une deuxième diode Schottky formant un deuxième détecteur est ainsi constituée par formation d'une deuxième zone de charge d'espace 118 dans le substrat 102 sous sa deuxième face 112 entre les deux conducteurs 114 et 116. Par symétrie du dispositif 100, cette deuxième zone de charge d'espace 118 est traversée par le même axe principal suivi par le faisceau de particules que la première zone de charge d'espace 110. L'anode 114 et la cathode 116, formant ainsi respectivement un contact Schottky et un contact ohmique de la deuxième diode Schottky, constituent des deuxièmes moyens collecteurs de porteurs de charges produits par une traversée du faisceau de particules dans la deuxième zone de charge d'espace 118.

On notera que pour que les deux zones de charge d'espace se forment correctement de part et d'autre du substrat 102, il faut que la distance L2 entre les deux collecteurs de chaque diode Schottky soit inférieure à L1.

On notera également l'extrême simplicité de ce dispositif monobloc de détection 100 à diodes Schottky. Tout en permettant une double détection par deux détecteurs indépendants comme exigé de plus en plus souvent, il permet de conserver de très bonnes propriétés de transparence aux particules, de compacité et de coûts de fabrication.

On notera également que dans le mode de réalisation de la figure 1, la couche de substrat 102 s'étend dans tout le matériau semi-conducteur.

Le dispositif monobloc 200 de détection de particules représenté schématiquement en coupe sur la figure 2 diffère du précédent par les caractéristiques suivantes :
- il présente une couche supplémentaire supérieure 220 en matériau semi-conducteur entre sa couche de substrat 202 et sa couche supérieure de matériau conducteur métallique constituée de deux conducteurs métalliques disjoints 206 et 208 formant respectivement l'anode et la cathode d'une première diode Schottky à zone de charge d'espace 210, et
- il présente une couche supplémentaire inférieure 222 en matériau semi-conducteur entre sa couche de substrat 202 et sa couche inférieure de matériau conducteur métallique constituée de deux conducteurs métalliques disjoints 214 et 216 formant respectivement l'anode et la cathode d'une deuxième diode Schottky à zone de charge d'espace 218.

Le substrat 202 est par exemple, comme le substrat 102, dopé n++. La couche supplémentaire supérieure 220 est par exemple dopée n- et formée par épitaxie au-dessus de la couche de substrat 202 dans le même matériau semi-conducteur, avec sa face supérieure libre 204 au contact des collecteurs 206 et 208. De même, la couche supplémentaire inférieure 222 est par exemple dopée n- et formée par épitaxie en dessous de la couche de substrat 202 dans le même matériau semi-conducteur, avec sa face inférieure libre 212 au contact des collecteurs 214 et 216.

L'intérêt de ce mode de réalisation par rapport au précédent est d'étendre les zones de charge d'espace 210 et 218 dans l'épaisseur du matériau semi-conducteur sans toutefois faire disparaître les charges dans le substrat 202 au détriment des cathodes 208 et 216 par exemple. Un compromis doit être trouvé entre le dopage n-des couches 220 et 222, l'épaisseur de ce dopage n- et la distance entre les électrodes 206 et 208 ou 214 et 216. Ce compromis est à la portée de l'homme du métier.

On notera qu'en variante la couche de substrat 202 pourrait être dopée p++, la couche supplémentaire supérieure 220 dopée p- et la couche supplémentaire inférieure 222 dopée p- également.

On notera également que dans le mode de réalisation de la figure 2, la couche de substrat 202 ne s'étend pas dans tout le matériau semi-conducteur et n'inclut notamment pas les couches dopées 220 et 222 qui n'en sont pas des régions. Il en sera de même dans les autres modes de réalisation qui vont suivre, où la couche de substrat ne s'étend pas dans tout le matériau semi-conducteur et n'inclut pas les « couches supplémentaires », « portions de couches supplémentaires », « autres couches supplémentaires » ou « autres portions de couches supplémentaires » qui y seront éventuellement définies.

Le dispositif monobloc 300 de détection de particules représenté schématiquement en coupe sur la figure 3 diffère du précédent par les caractéristiques suivantes :
- il présente une couche tampon supérieure 324 en matériau semi-conducteur entre sa couche de substrat 302 et sa couche supplémentaire supérieure 320 en matériau semi-conducteur, et
- il présente une couche tampon inférieure 326 en matériau semi-conducteur entre sa couche de substrat 302 et sa couche supplémentaire inférieure 322 en matériau semi-conducteur.

Comme le précédent, il comporte une couche supérieure de matériau conducteur métallique, directement au contact de la face supérieure libre 304 de la couche supplémentaire supérieure 320 en matériau semi-conducteur, constituée de deux conducteurs métalliques disjoints 306 et 308 formant respectivement l'anode et la cathode d'une première diode Schottky à zone de charge d'espace 310, ainsi qu'une couche inférieure de matériau conducteur métallique, directement au contact de la face inférieure libre 312 de la couche supplémentaire inférieure 322 en matériau semi-conducteur, constituée de deux conducteurs métalliques disjoints 314 et 316 formant respectivement l'anode et la cathode d'une deuxième diode Schottky à zone de charge d'espace 318.

Le substrat 302 est par exemple, comme le substrat 202, dopé n++. La couche tampon supérieure 324 est par exemple dopée n+ et formée par épitaxie au-dessus de la couche de substrat 302 dans le même matériau semi-conducteur. La couche supplémentaire supérieure 320 est par exemple, comme la couche supplémentaire supérieure 220, dopée n- et formée par épitaxie au-dessus de la couche tampon supérieure 324 dans le même matériau semi-conducteur. De même, la couche tampon inférieure 326 est par exemple dopée n+ et formée par épitaxie en dessous de la couche de substrat 302 dans le même matériau semi-conducteur. La couche supplémentaire inférieure 322 est par exemple dopée n- et formée par épitaxie en dessous de la couche tampon inférieure 326 dans le même matériau semi-conducteur.

L'intérêt de ce mode de réalisation par rapport au précédent est d'éviter la remontée d'impuretés du substrat 302 dopé n++ vers les couches supplémentaires supérieures et inférieures 320 et 322 en matériau semi-conducteur lors de la réalisation de l'épitaxie. Le dopage intermédiaire n+ des deux couches tampon 324 et 326 le permet. On notera que même s'il s'agit d'un mode de fabrication connu dans le domaine du semi-conducteur pour la fabrication de dispositifs de puissance, ce n'est pas le cas pour la fabrication de dispositifs de détection.

On notera également qu'en variante la couche de substrat 302 pourrait être dopée p++, la couche supplémentaire supérieure 320 dopée p-, la couche supplémentaire inférieure 322 dopée p- également et les deux couches tampon 324, 326 dopées p+.

On notera par ailleurs que dans les modes de réalisation des figures 1, 2 et 3, les diodes Schottky sont formées par disposition des couches conductrices directement sur les deux faces de la couche de substrat, ou indirectement via des couches supplémentaires en matériau semi-conducteur formées par épitaxie à partir de la couche de substrat.

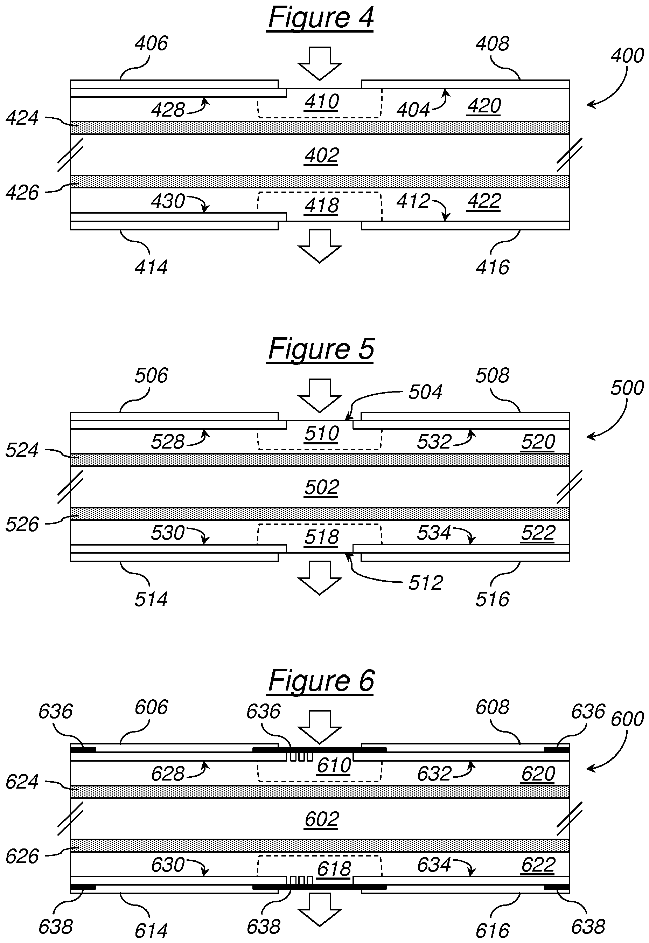

Le dispositif monobloc 400 de détection de particules représenté schématiquement en coupe sur la figure 4 comporte, comme le précédent :
- une couche de substrat 402 en matériau semi-conducteur dopé n++,
- une couche tampon supérieure 424 en matériau semi-conducteur dopé n+ formée par épitaxie au-dessus de la couche de substrat 402,
- une couche supplémentaire supérieure 420 en matériau semi-conducteur dopé n- formée par épitaxie au-dessus de la couche tampon supérieure 424,
- une couche supplémentaire supérieure de matériau conducteur métallique, au contact de la face supérieure libre 404 de la couche supplémentaire supérieure 420 en matériau semi-conducteur, constituée de deux conducteurs métalliques disjoints 406 et 408 formant respectivement l'anode et la cathode d'une première diode à zone de charge d'espace 410,
- une couche tampon inférieure 426 en matériau semi-conducteur dopé n+ formée par épitaxie en dessous de la couche de substrat 402,
- une couche supplémentaire inférieure 422 en matériau semi-conducteur dopé n- formée par épitaxie en dessous de la couche tampon inférieure 426,
- une couche supplémentaire inférieure de matériau conducteur métallique, directement, au contact de la face inférieure libre 412 de la couche supplémentaire inférieure 422 en matériau semi-conducteur, constituée de deux conducteurs métalliques disjoints 414 et 416 formant respectivement l'anode et la cathode d'une première diode à zone de charge d'espace 418.

Le dispositif monobloc 400 de détection de particules représenté schématiquement en coupe sur la figure 4 diffère toutefois du précédent par les caractéristiques suivantes :
- il présente localement une portion de couche supplémentaire supérieure 428, formée dans le matériau semi-conducteur par épitaxie avec un dopage p+ et s'interposant entre la couche supplémentaire supérieure 420 en matériau semi-conducteur dopé n- et l'anode 406 de sorte que cette dernière ne soit pas au contact direct du matériau semi-conducteur dopé n-, et
- il présente localement une portion de couche supplémentaire inférieure 430, formée dans le matériau semi-conducteur par épitaxie avec un dopage p+ et s'interposant entre la couche supplémentaire inférieure 422 en matériau semi-conducteur dopé n- et l'anode 414 de sorte que cette dernière ne soit pas au contact direct du matériau semi-conducteur dopé n-.

Il en résulte que les contacts Schottky précédemment évoqués sont remplacés par des contacts ohmiques, de telle sorte que la première diode formant le premier détecteur et la deuxième diode formant le deuxième détecteur deviennent des diodes PIN à dopage p (généralement notées diodes PI).

On notera qu'en variante la couche de substrat 402 pourrait être dopée p++, la couche supplémentaire supérieure 420 dopée p-, la couche supplémentaire inférieure 422 dopée p- également, les deux couches tampon 424, 426 dopées p+ et les deux portions de couches supplémentaires dopées n+. Il en résulterait deux détecteurs formés de deux diodes PIN à dopage n (généralement notées diodes NI).

Le dispositif monobloc 500 de détection de particules représenté schématiquement en coupe sur la figure 5 comporte des éléments 502 à 530 respectivement identiques aux éléments 402 à 430 du précédent.

Il diffère toutefois du précédent en ce que :
- il présente localement une autre portion de couche supplémentaire supérieure 532, formée dans le matériau semi-conducteur par épitaxie avec un dopage n++ et s'interposant entre la couche supplémentaire supérieure 520 en matériau semi-conducteur dopé n- et la cathode 508 de sorte que cette dernière ne soit pas au contact direct du matériau semi-conducteur dopé n-, et
- il présente localement une autre portion de couche supplémentaire inférieure 534, formée dans le matériau semi-conducteur par épitaxie avec un dopage n++ et s'interposant entre la couche supplémentaire inférieure 522 en matériau semi-conducteur dopé n- et la cathode 516 de sorte que cette dernière ne soit pas au contact direct du matériau semi-conducteur dopé n-.

Il en résulte que la première diode formant le premier détecteur et la deuxième diode formant le deuxième détecteur deviennent des diodes PIN à dopages p et n (généralement notées diodes PIN). Cela permet une meilleure récolte des porteurs de charges.

On notera qu'en variante la couche de substrat 502 pourrait être dopée p++, la couche supplémentaire supérieure 520 dopée p-, la couche supplémentaire inférieure 522 dopée p- également, les deux couches tampon 524, 526 dopées p+, les deux portions de couches supplémentaires 528, 530 dopées n+ et les deux autres portions de couches supplémentaires 532, 534 dopées p++. Il en résulterait deux détecteurs formés de deux diodes PIN à dopages n et p (généralement notées diodes NIP).

Le dispositif monobloc 600 de détection de particules représenté schématiquement en coupe sur la figure 6 comporte des éléments 602 à 634 respectivement identiques aux éléments 502 à 534 du précédent.

Il diffère toutefois du précédent en ce que :
- sa portion de couche supplémentaire supérieure 628, dopée p+ et s'interposant entre la couche supplémentaire supérieure 620 en matériau semi-conducteur dopé n- et l'anode 606, présente un dopage en caissons dans la zone de charge d'espace 610, c'est-à-dire par extension latérale de terminaison de jonction (de l'anglais « latéral junction termination extension » ou « lateral JTE ») dans la zone de charge d'espace 610,
- sa portion de couche supplémentaire inférieure 630, dopée p+ et s'interposant entre la couche supplémentaire inférieure 622 en matériau semi-conducteur dopé n- et l'anode 614, présente un dopage en caissons dans la zone de charge d'espace 618, c'est-à-dire par extension latérale de terminaison de jonction (de l'anglais « latéral junction termination extension » ou « lateral JTE ») dans la zone de charge d'espace 618,
- plusieurs portions d'une couche d'oxyde supérieure 636 sont ajoutées sur la face supérieure de la couche supplémentaire supérieure 620 en matériau semi-conducteur ou sur celle des portions de couches supplémentaires supérieures 628, 632 formées dans le même matériau semi-conducteur, notamment entre l'anode 606 et la cathode 608, et
- plusieurs portions d'une couche d'oxyde inférieure 638 sont ajoutées sur la face inférieure de la couche supplémentaire inférieure 622 en matériau semi-conducteur ou sur celle des portions de couches supplémentaires inférieures 630, 634 formées dans le même matériau semi-conducteur, notamment entre l'anode 614 et la cathode 616.

Le dopage en caissons des portions de couches supplémentaires 628, 630 dopées p+ permet un contrôle spatial des zones de charge d'espace 610, 618 en lissant les champs électrostatiques qui y sont engendrés, c'est-à-dire en créant des lignes de champs plus souples de manière à éviter des pointes de champs. Les caissons sont dopés selon le même type que la portion de couche supplémentaire 628 ou 630 qu'ils étendent. Leur configuration plus précise et leur répartition en fonction des configurations et dispositions des autres éléments du dispositif sont à la portée de l'homme du métier.

L'oxydation des faces supérieures et inférieures précitées notamment entre les anodes et cathodes des deux diodes PIN permet de neutraliser des liaisons pendantes et les perturbations électriques résultantes qui peuvent être créées par fabrication.

Par ailleurs, comme dans les modes de réalisation précédents, il est tout à fait possible d'inverser les dopages n et p des différentes couches en matériau semi-conducteur du dispositif monobloc 600.

On notera également que dans les modes de réalisation des figures 4, 5 et 6, les diodes PIN sont formées par disposition d'au moins un conducteur (en l'occurrence l'anode) de chaque couche conductrice au contact d'une portion de couche en matériau semi-conducteur formée avec un dopage inverse de celui de la couche de substrat, i.e. un dopage p quand le substrat est dopé n ou un dopage n quand le substrat est dopé p.

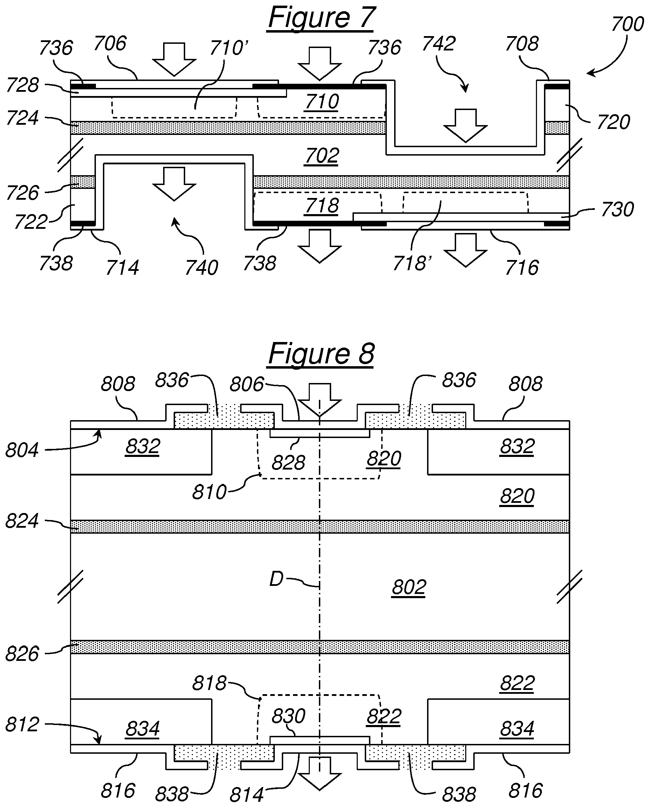

Le dispositif monobloc 700 de détection de particules représenté schématiquement en coupe sur la figure 7 comporte des éléments 702, 706, 716, 720, 722, 724, 726, 728 et 730 respectivement identiques aux éléments 402, 406, 416, 420, 422, 424, 426, 428 et 430 du dispositif monobloc 400 de la figure 4.

Il comporte en outre des portions de couches d'oxyde supérieure 736 et inférieure 738 comme le dispositif monobloc 600 de la figure 6.

Il présente par ailleurs les caractéristiques supplémentaires suivantes :
- un orifice 740 est creusé à partir de la face inférieure de l'empilement de couches en oxyde et en matériau semi-conducteur 738, 722, 726, 702, 724, 720, 728, depuis la couche d'oxyde 738 jusqu'à une certaine profondeur dans la couche de substrat 702, en vis-à-vis du conducteur 706,
- un orifice 742 est creusé à partir de la face supérieure de l'empilement de couches en oxyde et en matériau semi-conducteur 736, 720, 724, 702, 726, 722, 730, depuis la couche d'oxyde 736 jusqu'à une certaine profondeur dans la couche de substrat 702, en vis-à-vis du conducteur 716,
- une couche conductrice 714 est disposée au fond, en paroi latérale et en collerette (i.e. sous la couche d'oxyde 738) de l'orifice 740, et
- une couche conductrice 708 est disposée au fond, en paroi latérale et en collerette (i.e. sur la couche d'oxyde 736) de l'orifice 742.

Un avantage de cette configuration est d'amincir la partie du dispositif monobloc 700 susceptible d'être traversée par le faisceau de particules incident et donc d'améliorer sa transparence, en prévoyant deux orifices creusés dans le matériau semi-conducteur de part et d'autre de la couche de substrat 702 autour d'axes principaux destinés à être suivis par le faisceau de particules.

Par un premier choix approprié des épaisseurs et dimensions des différents éléments constitutifs du dispositif monobloc 700 :
- les couches conductrices 706 et 708 forment respectivement l'anode et la cathode d'une première diode PIN collectrice de porteurs de charges, la zone de charge d'espace 710 correspondante étant formée, comme la zone de charge d'espace 410 du dispositif monobloc 400, dans l'épaisseur de la couche supplémentaire supérieure 720 en matériau semi-conducteur entre l'anode 706 et la cathode 708, et
- les couches conductrices 716 et 714 forment respectivement l'anode et la cathode d'une deuxième diode PIN collectrice de porteurs de charges, la zone de charge d'espace 718 correspondante étant formée, comme la zone de charge d'espace 418 du dispositif monobloc 400, dans l'épaisseur de la couche supplémentaire inférieure 722 en matériau semi-conducteur entre l'anode 716 et la cathode 714.

Par un deuxième choix approprié des épaisseurs et dimensions des différents éléments constitutifs du dispositif monobloc 700 :
- les couches conductrices 706 et 714 forment respectivement l'anode et la cathode d'une première diode PIN collectrice de porteurs de charges, la zone de charge d'espace 710' correspondante étant alors déportée vers la gauche, contrairement à la configuration précédente, dans l'épaisseur de la couche supplémentaire supérieure 720 en matériau semi-conducteur entre l'anode 706 et la cathode 714, et
- les couches conductrices 716 et 708 forment respectivement l'anode et la cathode d'une deuxième diode PIN collectrice de porteurs de charges, la zone de charge d'espace 718' correspondante étant alors déportée vers la droite, contrairement à la configuration précédente, dans l'épaisseur de la couche supplémentaire inférieure 722 en matériau semi-conducteur entre l'anode 716 et la cathode 708.

Selon ce deuxième choix de configuration, il est important que les dimensions latérales du dispositif monobloc 700 soient suffisamment faibles devant l'épaisseur du faisceau incident pour que les deux zones de charge d'espace 710' et 718' soient traversées par ce même faisceau.

Par ailleurs, comme dans les modes de réalisation précédents, il est tout à fait possible d'inverser les dopages n et p des différentes couches en matériau semi-conducteur du dispositif monobloc 700.

Par souci de simplicité, les modes de réalisation précédents ont été présentés sur la base d'une anode et d'une cathode par face de dispositif monobloc, de manière à constituer un détecteur collecteur de porteurs de charges par face, alors qu'il est tout à fait possible de multiplier le nombre de détecteurs en multipliant le nombre d'anodes et cathodes par face.

Le dispositif monobloc 800 de détection de particules représenté schématiquement en coupe sur la figure 8 est un exemple non limitatif de configuration permettant une telle multiplication des détecteurs. Il est de section cylindrique autour d'un axe de symétrie D indiqué en trait interrompu mixte et par les deux flèches descendantes illustrant le trajet suivi par le faisceau incident.

Comme les dispositifs des figures 2 à 7, il comporte plusieurs couches (cylindriques dans ce mode de réalisation) d'un même matériau semi-conducteur, par exemple du carbure de silicium de formule SiC-4H, parmi lesquelles :
- une couche de substrat 802 en matériau semi-conducteur dopé n++, présentant une épaisseur de 100 à 300 µm,
- une couche tampon supérieure 824 en matériau semi-conducteur dopé n+ formée par épitaxie au-dessus de la couche de substrat 802, présentant une épaisseur d'environ 5 µm,
- une couche supplémentaire supérieure 820 en matériau semi-conducteur dopé n- formée par épitaxie au-dessus de la couche tampon supérieure 824, présentant une épaisseur de 1 à 3 µm,
- une autre couche supplémentaire supérieure 832, de forme annulaire, en matériau semi-conducteur formée avec un dopage n++ implanté dans la couche supplémentaire supérieure 820 en matériau semi-conducteur dopé n-, jusqu'à une certaine profondeur présentant une épaisseur d'environ 1 µm,
- une portion de couche centrale supérieure 828 formée avec un dopage p+ dans la couche supplémentaire supérieure 820 en matériau semi-conducteur dopé n-, à l'intérieur de l'anneau formé par l'autre couche supplémentaire supérieure 832 dopée n++,
- une couche tampon inférieure 826 en matériau semi-conducteur dopé n+ formée par épitaxie en dessous de la couche de substrat 802, présentant une épaisseur d'environ 5 µm,
- une couche supplémentaire inférieure 822 en matériau semi-conducteur dopé n- formée par épitaxie en dessous de la couche tampon inférieure 826, présentant une épaisseur de 1 à 3 µm,
- une autre couche supplémentaire inférieure 834, de forme annulaire, en matériau semi-conducteur formée avec un dopage n++ implanté dans la couche supplémentaire inférieure 822 en matériau semi-conducteur dopé n-, jusqu'à une certaine profondeur présentant une épaisseur d'environ 1 µm, et
- une portion de couche centrale inférieure 830 formée avec un dopage p+ dans la couche supplémentaire inférieure 822 en matériau semi-conducteur dopé n-, à l'intérieur de l'anneau formé par l'autre couche supplémentaire inférieure 834 dopée n++.

En ce qui concerne les épaisseurs respectives des différentes couches précitées, on notera que l'échelle n'est pas respectée sur l'illustration schématique de la figure 8, ce qui n'a aucune incidence sur la bonne compréhension de ce mode de réalisation.

Sur la face supérieure 804 de l'autre couche supplémentaire supérieure 832 dopée n++ et de la portion de couche centrale supérieure 828 dopée p+, formées toutes deux dans la couche supplémentaire supérieure 820 en matériau semi-conducteur dopé n-, sont disposées :
- une couche centrale supérieure 806 en métal conducteur formant anode, par exemple en matériau Ni/Ti/AI/Ni d'épaisseur avoisinant 100 nm, se présentant sous la forme d'un disque à collerette extérieure disposé au-dessus et au contact uniquement de la portion de couche centrale supérieure 828 en matériau semi-conducteur dopé p+,
- une couche périphérique supérieure 808 en métal conducteur formant cathode, par exemple en matériau Ti/Ni d'épaisseur avoisinant 100 nm, se présentant sous la forme d'un anneau à collerette intérieure disposé au-dessus et au contact uniquement de l'autre couche supplémentaire supérieure 832 en matériau semi-conducteur dopé n++, et
- une couche d'oxyde supérieure 836 s'étendant dans le volume intérieur annulaire délimité par les collerettes respectives de l'anode 806 et de la cathode 808, par exemple en matériau SiO₂ et sur une épaisseur de 1 à 3 µm correspondant approximativement à la hauteur des collerettes.

Ainsi, la couche supplémentaire supérieure 820 en matériau semi-conducteur dopé n- s'étend en fait de la couche tampon supérieure 824 à la couche d'oxyde supérieure 836 dans le volume laissé libre entre la portion de couche centrale supérieure 828 et la couche annulaire supérieure 832.

Sur la face inférieure 812 de l'autre couche supplémentaire inférieure 834 dopée n++ et de la portion de couche centrale inférieure 830 dopée p+, formées toutes deux dans la couche supplémentaire inférieure 822 en matériau semi-conducteur dopé n-, sont disposées :
- une couche centrale inférieure 814 en métal conducteur formant anode, par exemple en matériau Ni/Ti/AI/Ni d'épaisseur avoisinant 100 nm, se présentant sous la forme d'un disque à collerette extérieure disposé en dessous et au contact uniquement de la portion de couche centrale inférieure 830 en matériau semi-conducteur dopé p+,
- une couche périphérique inférieure 816 en métal conducteur formant cathode, par exemple en matériau Ti/Ni d'épaisseur avoisinant 100 nm, se présentant sous la forme d'un anneau à collerette intérieure disposé en dessous et au contact uniquement de l'autre couche supplémentaire inférieure 834 en matériau semi-conducteur dopé n++, et
- une couche d'oxyde inférieure 838 s'étendant dans le volume intérieur annulaire délimité par les collerettes respectives de l'anode 814 et de la cathode 816, par exemple en matériau SiO₂ et sur une épaisseur de 1 à 3 µm correspondant approximativement à la hauteur des collerettes.

Ainsi, la couche supplémentaire inférieure 822 en matériau semi-conducteur dopé n- s'étend en fait de la couche tampon inférieure 826 à la couche d'oxyde inférieure 838 dans le volume laissé libre entre la portion de couche centrale inférieure 830 et la couche annulaire inférieure 834.

Il se forme ainsi une première zone de charge d'espace supérieure 810 en dessous de la portion de couche centrale supérieure 828 dans l'épaisseur de la couche 820 et autour de l'axe de symétrie D. De même, il se forme une deuxième zone de charge d'espace inférieure 818 au-dessus de la portion de couche centrale inférieure 830 dans l'épaisseur de la couche 822 et autour de l'axe de symétrie D. La disposition des couches successives de matériau semi-conducteur précitées permet de courber latéralement les lignes de champs et de récolter les porteurs de charges à l'aide de paires d'anode et cathode disposées sur la même face, supérieure ou inférieure, du dispositif monobloc 800. En particulier les zones de charge d'espace ne s'étendant pas en profondeur au-delà des couches 820 et 822, le substrat 802 ne remplit plus qu'une fonction de support mécanique.

Il est alors très facile de réaliser plusieurs détecteurs par face du dispositif monobloc 800 en isolant plusieurs secteurs angulaires conducteurs dans les disques 806, 814 et anneaux 808, 816. Par exemple, en isolant quatre quarts de disque dans chacun des disques conducteurs 806, 814 et quatre quarts d'anneau correspondants dans chacun des anneaux conducteurs 806, 814, on isole quatre diodes PIN supérieures et quatre diodes PIN inférieures. Avec cette configuration, il est en outre possible de concevoir un décalage angulaire autour de l'axe D de symétrie et de traversée du faisceau incident entre les diodes supérieures et les diodes inférieures, notamment un décalage à angle droit comme cela est requis dans certaines classes d'appareils ou dans certains standards pour la double détection.

On notera qu'en variante, il est possible d'imaginer d'autres dispositions pour multiplier le nombre de détecteurs sur chaque face d'un dispositif monobloc de détection selon la présente invention. En particulier une disposition matricielle ou autre d'un nombre N de détecteurs s'étendant latéralement sur chaque face permet d'envisager plusieurs doubles détections locales dans la section du faisceau de particules incident.

Il apparaît clairement qu'un dispositif monobloc de détection tel que l'un de ceux décrits précédemment permet de réduire l'encombrement et le coût tout en améliorant la transparence de la double détection de plus en plus exigée par souci de sécurité dans les systèmes à émission de particules.

Un autre avantage apparaît plus clairement dans le mode de réalisation de la figure 8 et concerne le circuit de conversion courant-tension (non illustré) en aval des détecteurs. En effet, la structure proposée sur cette figure présente l'avantage de posséder pour chaque diode constituée en surface du dispositif monobloc 800 sa propre anode mais surtout sa propre cathode. La polarisation sur chacune des cathodes que nécessite l'adaptation du circuit de conversion aux détecteurs est rendue possible grâce à cette structure qui devient essentielle car elle permet de répondre à deux exigences : posséder plusieurs sorties de signaux sur chacune des cathodes avec une polarisation très faible du détecteur. Une autre solution pourrait être d'inverser les zones de dopage dans le matériau semi-conducteur du dispositif monobloc 800. C'est tout à fait possible, mais c'est plus coûteux parce que le marché du matériau SiC est principalement dédié aux composants de puissance et, pour des raisons techniques, les plaquettes de SiC ne sont généralement pas développées avec des dopages positifs.

On notera par ailleurs que l'invention n'est pas limitée aux différents modes de réalisation décrits précédemment.

En particulier, tous les détecteurs envisagés dans les modes de réalisation décrits ci-dessus sont des diodes Schottky ou PIN. D'autres détecteurs à matériau semi-conducteur peuvent cependant être envisagés tels que des transistors (par exemple CMOS, JFET ou bipolaires).

Par ailleurs, il peut y avoir une dissymétrie des détecteurs disposés de part et d'autre du substrat d'un dispositif monobloc de détection selon la présente invention, comme par exemple des diodes différentes, des diodes et des transistors, etc.

Il apparaîtra plus généralement à l'homme de l'art que diverses modifications peuvent être apportées aux modes de réalisation décrits ci-dessus, à la lumière de l'enseignement qui vient de lui être divulgué, en restant dans le cadre de l'invention telle que définie par l'objet des revendications.

## Revendications

1. Dispositif monobloc (100 ; 200 ; 300 ; 400 ; 500 ; 600 ; 700 ; 800) de détection de particules à matériau semi-conducteur comportant :
- une couche de substrat (102 ; 202 ; 302 ; 402 ; 502 ; 602 ; 702 ; 802) formée dans le matériau semi-conducteur,
- au moins une couche supplémentaire (106, 108 ; 206, 208, 220 ; 306, 308, 320, 324 ; 406, 408, 420, 424, 428 ; 506, 508, 520, 524, 528, 532 ; 606, 608, 620, 624, 628, 632 ; 706, 708, 720, 724, 728 ; 806, 808, 820, 824, 828, 832) formée dans le matériau semi-conducteur et/ou dans au moins un matériau conducteur disposée sur une première face de la couche de substrat de manière à former au moins un premier détecteur comprenant :
• une première zone de charge d'espace électronique (110 ; 210 ; 310 ; 410 ; 510 ; 610 ; 710, 710' ; 810) traversée par un premier axe du dispositif de détection destiné à être suivi par un faisceau de particules, et
• des premiers moyens à anode et cathode (106, 108 ; 206, 208 ; 306, 308 ; 406, 408 ; 506, 508 ; 606, 608 ; 706, 708 ; 806, 808) collecteurs de porteurs de charges produits par une traversée du faisceau de particules dans la première zone de charge d'espace,
**caractérisé en ce qu'**il comporte en outre au moins une autre couche supplémentaire (114, 116; 214, 216, 222 ; 314, 316, 322, 326 ; 414, 416, 422, 426, 430 ; 514, 516, 522, 526, 530, 534 ; 614, 616, 622, 626, 630, 634 ; 714, 716, 722, 726, 730 ; 814, 816, 822, 826, 830, 834) formée dans le matériau semi-conducteur et/ou dans ledit au moins un matériau conducteur disposée sur une deuxième face de la même couche de substrat, opposée à la première face, de manière à former au moins un deuxième détecteur indépendant du premier à partir de cette même couche de substrat et comprenant :
- une deuxième zone de charge d'espace électronique (118 ; 218 ; 318 ; 418 ; 518 ; 618 ; 718, 718' ; 818), traversée par un deuxième axe du dispositif de détection parallèle au premier axe et destiné à être également suivi par le faisceau de particules, et
- des deuxièmes moyens à anode et cathode (114, 116 ; 214, 216 ; 314,316 ; 414, 416 ; 514, 516 ; 614, 616 ; 714, 716 ; 814, 816) collecteurs de porteurs de charges produits par une traversée du faisceau de particules dans la deuxième zone de charge d'espace,
**caractérisé en ce que** ces deuxièmes moyens collecteurs sont électriquement isolés des premiers moyens collecteurs pour assurer l'indépendance des premier et deuxième détecteurs.

2. Dispositif monobloc (100; 200 ; 300) de détection de particules selon la revendication 1, dans lequel :
- ladite au moins une couche supplémentaire comporte :
• une première couche supplémentaire formée dans ledit au moins un matériau conducteur (106, 108 ; 206, 208 ; 306, 308), disposée directement sur la première face (104) de la couche de substrat (102 ; 202 ; 302), ou
• une première couche supplémentaire formée dans le matériau semi-conducteur (220 ; 320, 324) par épitaxie à partir de la couche de substrat et la première couche supplémentaire formée dans ledit au moins un matériau conducteur (106, 108 ; 206, 208 ; 306, 308) disposée indirectement sur la première face (104) de la couche de substrat (102 ; 202 ; 302) via cette première couche supplémentaire formée dans le matériau semi-conducteur (220 ; 320, 324),
de manière à former une anode (106 ; 206 ; 306) et une cathode (108 ; 208 ; 308) d'une première diode Schottky, et
- ladite au moins une autre couche supplémentaire comporte :
• une deuxième couche supplémentaire formée dans ledit au moins un matériau conducteur (114, 116; 214, 216 ; 314, 316), disposée directement sur la deuxième face (112) de la couche de substrat (102 ; 202 ; 302), ou
• une deuxième couche supplémentaire formée dans le matériau semi-conducteur (222 ; 322, 326) par épitaxie à partir de la couche de substrat et la deuxième couche supplémentaire formée dans ledit au moins un matériau conducteur (114, 116; 214, 216 ; 314, 316) disposée indirectement sur la deuxième face (112) de la couche de substrat (102 ; 202 ; 302) via cette deuxième couche supplémentaire formée dans le matériau semi-conducteur (222 ; 322, 326),
de manière à former une anode (114 ; 214 ;314) et une cathode (116 ; 216 ; 316) d'une deuxième diode Schottky.

3. Dispositif monobloc (400 ; 500 ; 600 ; 700 ; 800) de détection de particules selon la revendication 1, dans lequel :
- ladite au moins une couche supplémentaire comporte au moins une première portion de couche supplémentaire (428 ; 528 ; 628 ; 728 ; 828) formée dans le matériau semi-conducteur avec un dopage inverse de celui de la couche de substrat (402 ; 502 ; 602 ; 702 ; 802) et une première couche supplémentaire formée dans ledit au moins un matériau conducteur (406, 408 ; 506, 508 ; 606, 608 ; 706, 708 ; 806, 808) dont au moins un conducteur (406 ; 506 ; 606 ; 706 ; 806) est au contact de ladite au moins une première portion de couche supplémentaire (428 ; 528 ; 628 ; 728 ; 828) formée dans le matériau semi-conducteur, de manière à former une première diode PIN, et
- ladite au moins une autre couche supplémentaire comporte au moins une deuxième portion de couche supplémentaire (430 ; 530 ; 630 ; 730 ; 830) formée dans le matériau semi-conducteur avec un dopage inverse de celui de la couche de substrat (402 ; 502 ; 602 ; 702 ; 802) et une deuxième couche supplémentaire formée dans ledit au moins un matériau conducteur (414, 416 ; 514, 516 ; 614, 616 ; 714, 716 ; 814, 816) dont au moins un conducteur (414 ; 514 ; 614 ; 716 ; 814) est au contact de ladite au moins une deuxième portion de couche supplémentaire (430 ; 530 ; 630 ; 730 ; 830) formée dans le matériau semi-conducteur, de manière à former une deuxième diode PIN.

4. Dispositif monobloc (300 ; 400 ; 500 ; 600 ; 700 ; 800) de détection de particules selon l'une quelconque des revendications 1 à 3, comportant deux couches tampon (324, 326 ; 424, 426 ; 524, 526 ; 624, 626 ; 724, 726 ; 824, 826) respectivement formées par épitaxie à partir des première et deuxième faces de la couche de substrat (302 ; 402 ; 502 ; 602 ; 702 ; 802).

5. Dispositif monobloc (700) de détection de particules selon l'une quelconque des revendications 1 à 4, comportant deux orifices (740, 742) creusés dans le matériau semi-conducteur de part et d'autre de la couche de substrat (702) autour respectivement des premier et deuxième axes parallèles destinés à être suivis par le faisceau de particules.

6. Dispositif monobloc (100 ; 200 ; 300 ; 400 ; 500 ; 600 ; 700 ; 800) de détection de particules selon l'une quelconque des revendications 1 à 5, dans lequel la couche de substrat (102 ; 202 ; 302 ; 402 ; 502 ; 602 ; 702 ; 802) est dopée n++.

7. Dispositif monobloc (800) de détection de particules selon l'une quelconque des revendications 1 à 6, dans lequel sont formés plusieurs premiers détecteurs et plusieurs deuxièmes détecteurs.

8. Dispositif monobloc (100 ; 200 ; 300 ; 400 ; 500 ; 600 ; 700 ; 800) de détection de particules selon l'une quelconque des revendications 1 à 7, dans lequel ledit au moins un deuxième détecteur est formé de manière à présenter des diodes en décalage angulaire à angle droit par rapport à des diodes correspondantes dudit au moins un premier détecteur autour de la direction commune des premier et deuxième axes parallèles destinés à être suivis par le faisceau de particules.

9. Dispositif monobloc (100 ; 200 ; 300 ; 400 ; 500 ; 600 ; 700 ; 800) de détection de particules selon l'une quelconque des revendications 1 à 8, dans lequel les premier et deuxième axes parallèles sont confondus.

## Patentansprüche

1. Einteilige Vorrichtung (100; 200; 300; 400; 500; 600; 700; 800) zum Nachweis von Partikeln mit Halbleitermaterial, die Folgendes umfasst:
- eine Substratschicht (102; 202; 302; 402; 502; 602; 702; 802), die aus dem Halbleitermaterial gebildet ist,
- mindestens eine zusätzliche Schicht (106, 108; 206, 208, 220; 306, 308, 320, 324; 406, 408, 420, 424, 428; 506, 508, 520, 524, 528, 532; 606, 608, 620, 624, 628, 632; 706, 708, 720 724, 728; 806, 808, 820, 824, 828, 832), die in dem Halbleitermaterial und/oder in mindestens einem leitenden Material ausgebildet ist und auf einer ersten Seite der Substratschicht angeordnet ist, um mindestens einen ersten Detektor zu bilden, der Folgendes umfasst:
- eine erste Ladungszone für Elektronenraum (110; 210; 310; 410; 510; 610; 710; 710'; 810), durch die eine erste Achse der Erfassungsvorrichtung verläuft, die dazu bestimmt ist, von einem Partikelstrahl verfolgt zu werden,
und
- erste Anoden- und Kathodenmittel (106, 108; 206, 208; 360, 308; 406, 408; 506, 508; 606, 608; 706, 708; 806, 808), die Ladungsträger sammeln, die durch einen Durchgang des Partikelstrahls in der ersten Raumladungszone erzeugt werden,
**dadurch gekennzeichnet, dass** er außerdem mindestens eine weitere zusätzliche Schicht aufweist (114, 116; 214, 216, 222; 314, 316, 322, 326; 414, 416, 422, 426, 430; 514, 516, 522, 526, 530, 534; 614, 616, 622, 626, 630, 634; 714, 716, 722, 726, 730; 814, 816, 822, 826, 830, 834), die in dem Halbleitermaterial und/oder in dem mindestens einen leitenden Material gebildet ist, die auf einer zweiten Seite der gleichen Substratschicht gegenüber der ersten Seite angeordnet ist, um mindestens einen zweiten Detektor zu bilden, der unabhängig von dem ersten aus dieser gleichen Substratschicht ist, und die Folgendes umfasst:
- eine zweite Ladungszone für Elektronenraum (118; 218; 318; 418; 518; 618; 718; 718'; 818), die von einer zweiten Achse der Erfassungsvorrichtung parallel zur ersten Achse durchquert wird und dazu bestimmt ist, ebenfalls vom Partikelstrahl verfolgt zu werden, und
- zweite Anoden- und Kathodenmittel (114, 116; 214, 216; 314, 316; 414, 416; 514, 516; 614, 616; 714, 716; 814, 816), die Ladungsträger sammeln, die durch einen Durchgang des Partikelstrahls in der zweiten Raumladungszone erzeugt werden, **dadurch gekennzeichnet, dass** diese zweiten Sammelmittel von den ersten Sammelmitteln elektrisch isoliert sind, um die Unabhängigkeit des ersten und des zweiten Detektors zu gewährleisten.

2. Einteilige Vorrichtung (100; 200; 300) zum Nachweis von Partikeln nach Anspruch 1, wobei:
- die mindestens eine zusätzliche Schicht umfasst:
- eine erste zusätzliche Schicht, die in dem mindestens einen leitfähigen Material (106, 108; 206, 208; 306, 308) ausgebildet ist und direkt auf der ersten Seite (104) der Substratschicht (102; 202; 302) angeordnet ist, oder
- eine erste zusätzliche Schicht, die in dem Halbleitermaterial (220; 320; 324) durch Epitaxie aus der Substratschicht gebildet ist, und die erste zusätzliche Schicht, die in dem mindestens einen leitenden Material (106, 108; 206, 208; 306, 308) gebildet ist, indirekt auf der ersten Seite (104) der Substratschicht (102; 202; 302) über diese erste zusätzliche Schicht, die in dem Halbleitermaterial (220; 320, 324) gebildet ist, angeordnet ist,
um eine Anode (106; 206; 306) und eine Kathode (108; 208; 308) einer ersten Schottky-Diode zu bilden, und
- die mindestens eine weitere zusätzliche Schicht umfasst:
- eine zweite zusätzliche Schicht, die in dem mindestens einen leitenden Material (114, 116; 214, 216; 314, 316) ausgebildet ist und direkt auf der zweiten Seite (112) der Substratschicht (102; 202; 302) angeordnet ist, oder
- eine zweite zusätzliche Schicht, die in dem Halbleitermaterial (222; 322, 326) durch Epitaxie aus der Substratschicht gebildet ist, und die zweite zusätzliche Schicht, die in dem mindestens einen leitenden Material (114, 116; 214, 216; 314, 316) gebildet ist, indirekt auf der zweiten Seite (112) der Substratschicht (102; 202; 302) über diese zweite zusätzliche Schicht, die in dem Halbleitermaterial (222; 322, 326) gebildet ist, angeordnet ist,
um eine Anode (114; 214; 314) und eine Kathode (116; 216; 316) einer zweiten Schottky-Diode zu bilden.

3. Einteilige Vorrichtung (400; 500; 600; 700; 800) zum Nachweis von Partikeln nach Anspruch 1, wobei:
- die mindestens eine zusätzliche Schicht mindestens einen ersten zusätzlichen Schichtabschnitt (428; 528; 628; 728; 828), der in dem Halbleitermaterial mit einer Dotierung umgekehrt zu der der Substratschicht (402; 502; 602; 702; 802) gebildet ist, und eine erste zusätzliche Schicht, die in dem mindestens einen leitenden Material (406, 408; 506, 508; 606, 608; 706, 708; 806, 808) gebildet ist, umfasst, von dem mindestens ein Leiter (406; 506; 606; 706; 806) den mindestens einen ersten zusätzlichen Schichtabschnitt (428; 528; 628; 728; 828) kontaktiert, der in dem Halbleitermaterial gebildet ist, um eine erste PIN-Diode zu bilden,
und
- die mindestens eine weitere zusätzliche Schicht mindestens einen zweiten zusätzlichen Schichtabschnitt (430; 530; 630; 730; 830), der in dem Halbleitermaterial mit einer Dotierung umgekehrt zu der der Substratschicht (402; 502; 602; 702; 802) gebildet ist, und eine zweite zusätzliche Schicht, die in dem mindestens einen leitenden Material (414, 416; 514, 516; 614, 616; 714, 716; 814, 816) gebildet ist, umfasst, von dem mindestens ein Leiter (414; 514; 614; 716; 814) den mindestens einen zweiten zusätzlichen Schichtabschnitt (430; 530; 630; 730; 830) kontaktiert, der in dem Halbleitermaterial gebildet ist, um eine zweite PIN-Diode zu bilden.

4. Einteilige Vorrichtung (300; 400; 500; 600; 700; 800) zum Nachweis von Partikeln nach einem der Ansprüche 1 bis 3, mit zwei Pufferschichten (324, 326; 424, 426; 524, 526; 624, 626; 724, 726; 824, 826), die jeweils durch Epitaxie von der ersten und zweiten Seite der Substratschicht (302; 402; 502; 602; 702; 802) gebildet werden.

5. Einteilige Vorrichtung (700) zum Nachweis von Partikeln nach einem der Ansprüche 1 bis 4, mit zwei Öffnungen (740, 742), die in das Halbleitermaterial auf beiden Seiten der Substratschicht (702) um die erste bzw. die zweite parallele Achse gegraben sind, die dazu bestimmt sind, von dem Partikelstrahl verfolgt zu werden.

6. Einteilige Vorrichtung (100; 200; 300; 400; 500; 600; 700; 800) zum Nachweis von Partikeln nach einem der Ansprüche 1 bis 5, wobei die Substratschicht (102; 202; 302; 402; 502; 602; 702; 802) n₊₊-dotiert ist.

7. Einteilige Vorrichtung (800) zum Nachweis von Partikeln nach einem der Ansprüche 1 bis 6, in der mehrere erste Detektoren und mehrere zweite Detektoren ausgebildet sind.

8. Einteilige Vorrichtung (100; 200; 300; 400; 500; 600; 700; 800) zum Nachweis von Partikeln nach einem der Ansprüche 1 bis 7; wobei der mindestens eine zweite Detektor so geformt ist, dass er Dioden aufweist, die rechtwinklig zu entsprechenden Dioden des mindestens einen ersten Detektors um die gemeinsame Richtung der ersten und zweiten parallelen Achsen, die von dem Partikelstrahl verfolgt werden sollen, versetzt sind.

9. Einteilige Vorrichtung (100; 200; 300; 400; 500; 600; 700; 800) zum Nachweis von Partikeln nach einem der Ansprüche 1 bis 8, wobei die erste und die zweite parallele Achse zusammenfallen.

## Claims

1. A one-piece device (100; 200; 300; 400; 500; 600; 700; 800) for detecting particles with semiconductor material comprising:
- a substrate layer (102; 202; 302; 402; 502; 602; 702; 802) formed in the semiconductor material,
- at least one additional layer (106, 108; 206, 208, 220; 306, 308, 320, 324; 406, 408, 420, 424, 428; 506, 508, 520, 524, 528, 532; 606, 608, 620, 624, 628, 632; 706, 708, 720, 724, 728; 806, 808, 820, 824, 828, 832) formed in the semiconductor material and/or in at least one conductive material disposed on a first face of the substrate layer so as to form at least a first detector comprising:
• a first electronic space charge zone (110; 210; 310; 410; 510; 610; 710, 710'; 810) through which a first axis of the detection device to be followed by a particle beam passes, and
• first collector means with anode and cathode (106, 108; 206, 208; 306, 308; 406, 408; 506, 508; 606, 608; 706, 708; 806, 808) for collecting charge carriers produced by the particle beam passing through the first space charge zone,
**characterized in that** it further comprises at least one other additional layer (114, 116; 214, 216, 222; 314, 316, 322, 326; 414, 416, 422, 426, 430; 514, 516, 522, 526, 530, 534; 614, 616, 622, 626, 630, 634; 714, 716, 722, 726, 730; 814, 816, 822, 826, 830, 834) formed in the semiconductor material and/or in said at least one conductive material disposed on a second face of the same substrate layer, opposite to the first face, so as to form at least a second detector independent of the first one from this same substrate layer and comprising:
- a second electronic space charge zone (118; 218; 318; 418; 518; 618; 718, 718'; 818), through which a second axis of the detection device parallel to the first axis and intended to be also followed by the particle beam passes, and
- second collector means with anode and cathode (114, 116; 214, 216; 314, 316; 414, 416; 514, 516; 614, 616; 714, 716; 814, 816) for collecting charge carriers produced by the particle beam passing through the second space charge zone, **characterized in that** said second collector means are electrically insulated from the first collector means to ensure independence of the first and second detectors.

2. The one-piece particle detection device (100; 200; 300) according to claim 1, wherein:
- said at least one additional layer comprises:
• a first additional layer formed in said at least one conductive material (106, 108; 206, 208; 306, 308) disposed directly on the first face (104) of the substrate layer (102; 202; 302), or
• a first additional layer formed in the semiconductor material (220; 320, 324) by epitaxy from the substrate layer and the first additional layer formed in said at least one conductive material (106, 108; 206, 208; 306, 308) disposed indirectly on the first face (104) of the substrate layer (102; 202; 302) via this first additional layer formed in the semiconductor material (220; 320, 324),
so as to form an anode (106; 206; 306) and a cathode (108; 208; 308) of a first Schottky diode, and
- said at least one other additional layer comprises:
• a second additional layer formed in said at least one conductive material (114, 116; 214, 216; 314, 316) disposed directly on the second face (112) of the substrate layer (102; 202; 302), or
• a second additional layer formed in the semiconductor material (222; 322, 326) by epitaxy from the substrate layer and the second additional layer formed in said at least one conductive material (114, 116; 214, 216; 314, 316) disposed indirectly on the second face (112) of the substrate layer (102; 202; 302) via this second additional layer formed in the semiconductor material (222; 322, 326),
so as to form an anode (114; 214; 314) and a cathode (116; 216; 316) of a second Schottky diode.

3. The one-piece particle detection device (400; 500; 600; 700; 800) according to claim 1, wherein:
- said at least one additional layer comprises at least one first additional layer portion (428; 528; 628; 728; 828) formed in the semiconductor material with a reverse doping to that of the substrate layer (402; 502; 602; 702; 802) and a first additional layer formed in said at least one conductive material (406, 408; 506, 508; 606, 608; 706, 708; 806, 808) of which at least one conductor (406; 506; 606; 706; 806) is in contact with said at least one first additional layer portion (428; 528; 628; 728; 828) formed in the semiconductor material, so as to form a first PIN diode, and
- said at least one other additional layer comprises at least one second additional layer portion (430; 530; 630; 730; 830) formed in the semiconductor material with a reverse doping to that of the substrate layer (402; 502; 602; 702; 802) and a second additional layer formed in said at least one conductive material (414, 416; 514, 516; 614, 616; 714, 716; 814, 816) of which at least one conductor (414; 514; 614; 716; 814) is in contact with said at least one second additional layer portion (430; 530; 630; 730; 830) formed in the semiconductor material, so as to form a second PIN diode.

4. The one-piece particle detection device (300; 400; 500; 600; 700; 800) according to any one of claims 1 to 3, comprising two buffer layers (324, 326; 424, 426; 524, 526; 624, 626; 724, 726; 824, 826) respectively formed by epitaxy from the first and second faces of the substrate layer (302; 402; 502; 602; 702; 802).

5. The one-piece particle detection device (700) according to any one of claims 1 to 4, comprising two holes (740, 742) hollowed out in the semiconductor material on either face of the substrate layer (702) about the first and second parallel axes that are intended to be followed by the particle beam respectively.

6. The one-piece particle detection device (100; 200; 300; 400; 500; 600; 700; 800) according to any one of claims 1 to 5, wherein the substrate layer (102; 202; 302; 402; 502; 602; 702; 802) is n++ doped.

7. The one-piece particle detection device (800) according to any one of claims 1 to 6, wherein a plurality of first detectors and a plurality of second detectors are formed.

8. The one-piece particle detection device (100; 200; 300; 400; 500; 600; 700; 800) according to any one of claims 1 to 7, wherein said at least one second detector is formed to have diodes angularly offset at right angles to corresponding diodes of said at least one first detector about the common direction of the first and second parallel axes intended to be followed by the particle beam.

9. The one-piece particle detection device (100; 200; 300; 400; 500; 600; 700; 800) according to any one of claims 1 to 8, wherein the first and second parallel axes are coincident
